**Europäisches Patentamt**

**European Patent Office**

**Office européen des brevets**

(19)

(11) Veröffentlichungsnummer: **0 042 014**
**B1**

(12) **EUROPÄISCHE PATENTSCHRIFT**

(45) Veröffentlichungstag der Patentschrift:
09.05.84

(51) Int. Cl.³: **H 04 B 3/36**, H 03 F 1/52

(21) Anmeldenummer: 80108203.3

(22) Anmeldetag: 24.12.80

(54) Überspannungsschutzschaltung für Leitungsverstärker.

(30) Priorität: 18.06.80 DE 3022677

(43) Veröffentlichungstag der Anmeldung:
23.12.81 Patentblatt 81/51

(45) Bekanntmachung des Hinweises auf die Patenterteilung:
09.05.84 Patentblatt 84/19

(84) Benannte Vertragsstaaten:
AT BE CH DE FR GB IT LI LU NL

(56) Entgegenhaltungen:
DE - A - 2 843 919
DE - B - 1 462 247
FR - A - 2 353 180

ELECTRICAL COMMUNICATION, Vol. 53, No. 2, 1978
London B.B. FOSTER et al. "NG-1 Submerged
Repeater"

(73) Patentinhaber: ANT Nachrichtentechnik GmbH,
Gerberstrasse 33, D-7150 Backnang (DE)

(72) Erfinder: Tischer, Friedrich-Christian, Dipl.-Ing.,
Kinzigstrasse 9, D-7150 Backnang (DE)
Erfinder: Kleinmann, Horst, Dipl.-Ing., Lutherweg 58,
D-7150 Backnang (DE)
Erfinder: Klinger, Herwig, Ing. grad., Kolberger
Strasse 10, D-7150 Backnang (DE)

(74) Vertreter: Schickle, Gerhard, Dipl.-Ing. et al, ANT
Nachrichtentechnik GmbH Patent- und Lizenzabteilung
Gerberstrasse 33, D-7150 Backnang (DE)

## Beschreibung

Die Erfindung betrifft eine Überspannungsschutzschaltung für einen über die Leitung ferngespeisten Leitungsverstärker gemäss dem Oberbegriff des Hauptanspruchs.

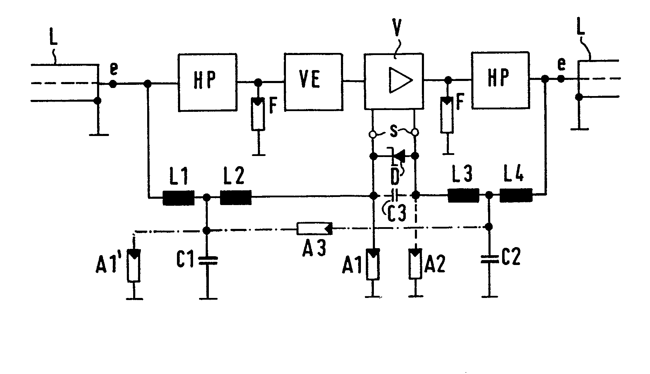

Solche Überspannungsschutzschaltungen sind bekannt, beispielsweise aus «Technische Mitteilungen AEG-TELEFUNKEN, Beiheft: Analoge Übertragungseinrichtungen, 1977, Seite 72 bzw. Bild 1 auf S. 71», aus der DE-B-1462247 und aus der FR-A1-2353180. Bei diesen bekannten Schutzschaltungen sind jeweils an den Leitungsenden Überspannungsableiter vorgesehen, die bei Blitzeinschlägen oder Starkstrombeeinflussung zünden und so den Verstärker schützen. Beim Zünden der Überspannungsableiter entstehen jedoch steile Spannungssprünge, die im gesamten Übertragungsbereich der Leitungsverstärker hohe Energieanteile aufweisen und dadurch nicht nur die Übertragung beeinträchtigen, sondern sogar zu einem Schaden des Verstärkers führen können, wenn nicht zusätzlich Massnahmen ergriffen werden.

Durch die DE-A1-2843919 ist ein Leitungsverstärker mit einer Schaltungsanordnung zum eingangs- und ausgangsseitigen Überspannungsgrobschutz bekannt geworden, bei der nurmehr am Eingang des Leitungsverstärkers ein Überspannungsableiter vorgesehen ist. Dies hat den Vorteil, dass die erwähnten steilen Spannungssprünge bei Zünden der Überspannungsableiter nur auf den Verstärkereingang einwirken können, der jedoch üblicherweise mit einem Vorentzerrer ausgestattet ist, welcher den unteren bzw. den mittleren Übertragungsbereich stark bzw. schwach dämpft. Dadurch wird aber nur ein Teil der bei der Zündung des Überspannungsableiters entstehenden Impulsenergie, die im wesentlichen im ganzen Übertragungsbereich der Leitungsverstärker gleichmässig verteilt ist, eliminiert.

Aufgabe der Erfindung ist es daher, eine Überspannungsschutzschaltung für einen ferngespeisten Leitungsverstärker der obigen Art anzugeben, die einen besseren Schutz vor durch Zünden der Grobschutz-Überspannungsableiter entstehenden energiereichen hochfrequenten Impulsen bei kleinem Aufwand gewährt.

Die Lösung dieser Aufgabe erfolgt mit den in dem Patentanspruch 1 angegebenen Mitteln.

Die erfindungsgemässe Überspannungsschutzschaltung weist einen verbesserten Schutz gegen Überspannungen, hervorgerufen durch Blitz, EMP oder Starkstrombeeinflussungen, bei gleichem oder verringertem Aufwand gegenüber bekannten Schutzschaltungen auf.

Das Erfindungswesentliche liegt darin, dass auf Grobschutz-Überspannungsableiter an Ein- bzw. Ausgängen von Leitungsverstärkern verzichtet und dafür ein Grobschutz-Überspannungsableiter im Tiefpassweg der Stromspeisung vorgesehen wird.

Es folgt nun eine Beschreibung der Erfindung anhand der Figur. Die Figur zeigt im Zuge einer aufgetrennten koaxialen Leitung L einen Leitungsverstärker V, der an der Trennstelle zwischen den Leitungsenden e eingefügt ist. Vor den Verstärkereingang ist ein Vorentzerrer VE vorgeschaltet. Zwischen den Leitungsenden e und dem Verstärker sind jeweils eingangs- bzw. ausgangsseitig Stromversorgungsweichen eingefügt, die aus Hochpässen HP im Übertragungsweg und aus Tiefpassgliedern L1, C1, L2 bzw. L4, C2, L3 im Speisestromweg bestehen. Der Speisestromweg ist durch eine parallel an die Speiseeingänge s angeschaltete Schutzdiode D, eine Zener-Diode, gegen Überstrom geschützt. Für den Feinschutz ist der Verstärker ausgangsseitig und am Eingang des Vorentzerrers mit je einem Überspannungsableiter F (Ansprechspannung üblicherweise etwa 90-100 Volt) gegen Überspannungsimpulse hoher Flankensteilheit ausgestattet. Ein Grobschutz-Überspannungsableiter A1, der eine wesentlich grössere Ansprechspannung von ungefähr 1000 Volt und mehr aufweist und der gegen Überspannungsimpulse niedriger Flankensteilheit vorgesehen ist, ist erfindungsgemäss im Tiefpassweg der Stromeinspeisung für den Verstärker, vorteilhafterweise an einem Stromversorgungs- oder Speiseeingang s des Verstärkers, angeschaltet. Aufgrund dieser Anordnung kann ein langsamer Überspannungsimpuls, beispielsweise links von der Leitung L kommend, über das Tiefpass-T-Glied L1, C1, L2 oder aber auch vom rechten Leitungsteil L kommend über das ausgangsseitige Tiefpass-T-Glied L4, C2, L3 der Stromversorgungsweiche und die Schutzdiode D zum Überspannungsableiter A1 gelangen, der bei Erreichen der Zündspannung anspricht. Die dabei entstehenden mittel- und hochfrequenten energiereichen Impulse werden durch die beiden genannten T-Glieder sehr stark gedämpft, so dass nahezu keine Störenergie mehr auf Verstärkerein- und -ausgang gelangen kann.

Der erfindungsgemässe Überspannungsableiter A1 kann ergänzt werden durch einen weiteren Grobschutz-Überspannungsableiter A2 (gestrichelt gezeichnet), der an den anderen Speiseeingang s des Verstärkers V angeschaltet ist.

Es ist auch möglich, anstelle der Ableiter A1 und A2 einen bekannten Überspannungsableiter mit drei Elektroden einzusetzen, wobei die gemeinsame Elektrode an den Rückleiter und die beiden anderen Elektroden an die Speiseeingänge s gelegt werden. Die beiden Entladungsstrecken solcher Ableiter sind intern gekoppelt, so dass bei Zünden einer Strecke die andere nach sehr kurzer Zeitverzögerung ebenfalls zündet. Dadurch und durch einen der Zener-Diode D parallel geschalteten Kondensator C3 wird das Auftreten hoher Ströme in der Diode verhindert. Zum Schutze der Zener-Diode bietet sich auch eine andere vorteilhafte Lösung an, bei der in einer erfindungsgemässen Ausgestaltung ein Grobschutz-Überspannungsableiter A1' an den Sternpunkt des T-Gliedes angeschaltet ist und bei der ein dritter Überspannungsableiter A3 zwischen den Sternpunkten der beiden genannten T-Glieder der Stromversorgungsweichen geschaltet ist (strichpunktiert). Bei entsprechender Ausführung der beiden Induktivitäten L1 und L4 werden auch hier die bei Zündung der Grobschutz-Überspannungsableiter entstehenden energiereichen Impulse im Übertragungsband zum Verstärkerein- bzw. -ausgang genügend gedämpft.

**Patentansprüche**

1. Überspannungsschutzschaltung für einen über die Leitung ferngespeisten Leitungsverstärker (V), dessen Speiseeingänge (s) über eine Stromversorgungsweiche eine galvanische Verbindung mit den Leitungsenden (e) aufweisen, *dadurch gekennzeichnet,* dass als einziger Grobschutz ein Überspannungsableiter (A1, A2, A1') zwischen der galvanischen Verbindung und dem Rückleiter derart vorgesehen ist, dass zwischen Überspannungsableiter und den Leitungsenden (e) ein Tiefpassglied liegt.

2. Überspannungsschutzschaltung nach Anspruch 1, *dadurch gekennzeichnet,* dass das Tiefpassglied in den Stromversorgungsweichen enthalten ist.

3. Überspannungsschutzschaltung nach Anspruch 1 oder 2, *dadurch gekennzeichnet,* dass der Überspannungsableiter (A1 oder A2) an einen Speiseeingang (s) angeschaltet ist.

4. Überspannungsschutzschaltung nach Anspruch 1 oder 2, *dadurch gekennzeichnet,* dass an beiden Speiseeingängen (s) jeweils ein Überspannungsableiter (A1 und A2) angeschaltet ist.

5. Überspannungsschutzschaltung nach Anspruch 4, *dadurch gekennzeichnet,* dass die beiden Überspannungsableiter (A1 und A2) als gekoppelter Dreielektroden-Überspannungsableiter ausgeführt sind.

6. Überspannungsschutzschaltung nach einem der vorhergehenden Ansprüche, *dadurch gekennzeichnet,* dass parallel zu den Speiseeingängen (s) eine Zener-Diode (D) geschaltet ist.

7. Überspannungsschutzschaltung nach einem der vorhergehenden Ansprüche, *dadurch gekennzeichnet,* dass parallel zu den Speiseeingängen (s) ein weiterer Überspannungsableiter (A3) vorgesehen ist, der mit den Speiseeingängen (s) und mit den Leitungsenden (e) jeweils über ein Tiefpassglied verbunden ist.

**Claims**

1. Surge voltage protection circuit for a line amplifier (V), which is supplied remotely by way of the line and the supply inputs (s) of which display a conductive connection by way of a current supply separating filter with the line ends (e), characterised thereby, that a surge voltage arrester (A1, A2, A1') is provided as sole coarse protection between the conductive connection and the return conductor in such a manner that a low-pass filter link lies between surge voltage arrester and the line ends (e).

2. Surge voltage protection circuit according to claim 1, characterised thereby, that the low-pass filter link is contained in the current supply separating filters.

3. Surge voltage protection circuit according to claim 1 or 2, characterised thereby, that the surge voltage arrester (A1 or A2) is connected to a supply input (s).

4. Surge voltage protection circuit according to claim 1 or 2, characterised thereby, that a respective surge voltage arrester (A1 and A2) is connected to both supply inputs (s).

5. Surge voltage protection circuit according to claim 4, characterised thereby, that the two surge voltage arresters (A1 and A2) are constructed as coupled three-electrode surge voltage arresters.

6. Surge voltage protection circuit according to one of the preceding claims, characterised thereby, that a Zener diode (D) is connected in parallel with the supply inputs (s).

7. Surge voltage protection circuit according to one of the preceding claims, characterised thereby, that a further surge voltage arrester (A3), which is connected through a respective low-pass filter link with the supply inputs (s) and with the line ends (e), is provided in parallel with the supply inputs (s).

**Revendications**

1. Circuit pour protéger contre les surtensions un amplificateur de ligne (V) alimenté à distance à travers la ligne, dont les entrées d'alimentation (s) sont en liaison galvanique avec les extrémités de ligne (e) à travers un filtre de bande ou filtre séparateur d'alimentation, caractérisé en ce que, comme protection grossière unique, un dispositif de protection contre les surtensions ou parasurtensions (A1, A2, A1') est prévu de telle manière entre la liaison galvanique et le conducteur de retour qu'un élément formant filtre passe-bas est situé entre la parasurtension et les extrémités de ligne (e).

2. Circuit selon la revendication 1, caractérisé en ce que l'élément formant filtre passe-bas est contenu dans les filtres séparateurs d'alimentation.

3. Circuit selon la revendication 1 ou 2, caractérisé en ce que la parasurtension (A1 ou A2) est branchée sur une entrée d'alimentation (s).

4. Circuit selon la revendication 1 ou 2, caractérisé en ce qu'une parasurtension (A1 et A2) est branchée sur chacune des deux entrées d'alimentation (s).

5. Circuit selon la revendication 4, caractérisé en ce que les deux parasurtensions (A1 et A2) sont réalisées sous forme de parasurtensions à trois électrodes couplés entre eux.

6. Circuit selon une des revendications précédentes, caractérisé en ce qu'une diode Zener (D) est branchée parallèlement aux entrées d'alimentation (s).

7. Circuit selon une des revendications précédentes, caractérisé en ce qu'une parasurtension supplémentaire (A3) est prévue parallèlement aux entrées d'alimentation (s), laquelle est reliée chaque fois à travers un élément formant filtre passe-bas aux entrées d'alimentation (s) et aux extrémités de ligne (e).